# EUROPÄISCHE PATENTSCHRIFT

(11) **EP 1 902 325 B1**
(45) Veröffentlichungstag und Bekanntmachung des Hinweises auf die Patenterteilung: **06.05.2009**
(21) Anmeldenummer: 07723765.9
(22) Anmeldetag: 29.03.2007
(51) Int. Cl.: G01R 31/28

(54) **TESTVORRICHTUNG ZUM TESTEN VON ELEKTRONISCHEN BAUELEMENTEN**
TEST APPARATUS FOR TESTING ELECTRONIC COMPONENTS
DISPOSITIF DE TEST POUR TESTER DES COMPOSANTS ÉLECTRONIQUES

(30) Priorität: 03.04.2006 DE 102006015363
(43) Veröffentlichungstag der Anmeldung: 26.03.2008
(73) Patentinhaber: Multitest elektronische Systeme GmbH, 83026 Rosenheim (DE)
(72) Erfinder: SCHAULE, Maximilian, 87719 Mindelheim (DE); PETERMANN, Manuel, 83024 Rosenheim (DE); KURZ, Stefan, 83026 Rosenheim (DE); NAGY, Andreas, 81825 München (DE)
(74) Vertreter: Bauer, Friedrich
(86) Internationale Anmeldenummer: PCT/EP2007/002823
(87) Internationale Veröffentlichungsnummer: WO 2007/115698

(56) Entgegenhaltungen:
- US-A1- 2002 071 127
- US-A1- 2005 280 427
- US-A1- 2006 066 340

## Beschreibung

Die Erfindung betrifft eine Testvorrichtung zum Testen von elektronischen Bauelementen, insbesondere Halbleiterbausteinen, die in einem Verbund, insbesondere in der Form von Strips, vorliegen, gemäß dem Oberbegriff des Anspruches 1.

Halbleiter werden bekanntermaßen vor ihrer Montage auf Leiterplatten etc. einem Funktionstest unterzogen, wobei dies häufig unter bestimmten Temperaturbedingungen erfolgt. Beispielsweise können die Bauelemente in einem Temperaturbereich von -60 °C bis +170 °C getestet werden. Hierzu existieren Handhabungsautomaten, auch Handler genannt, welche die Bauelemente zu einem innerhalb des Handlers angeordneten Kontaktiernest transportieren. Das Kontaktiernest mit den Bauelementen wird anschließend an einem Testkopf angedockt, der die elektrische Verbindung zu einer elektronischen Recheneinheit schafft. Hierbei ist es bekannt, die Bauelemente nicht nur vereinzelt, sondern auch in einem Verbund, insbesondere in der Form von Strips (beispielsweise Lead Frames), zu testen. Dies ist insbesondere dann vorteilhaft, wenn es sich um sehr kleine Bauelemente handelt, die als vereinzelte Bauteile nur schwer handhabbar wären. Weiterhin können pro Zeiteinheit mehr Bauelemente getestet werden, wenn sie im Verbund auf einem Strip angeordnet sind, wodurch Testkosten reduziert werden können.

Befinden sich auf einem Strip sehr viele kleine Bauelemente, die häufig nur wenige Millimeter oder kleiner sein können, so ist es in der Regel nicht mehr möglich, das Kontaktierboard (DUT-Board oder "Device Under Test-Board") des Testkopfs mit derart vielen Kontaktpins oder Kontaktfedern auszubilden, dass sämtliche Bauelemente eines Strips gleichzeitig kontaktiert und getestet werden können. Einer der Gründe liegt beispielsweise darin, dass für jeden Kontaktstift bzw. jede Kontaktfeder eine eigene Leitung zur dahinter angeordneten Auswerte- und Recheneinheit vorgesehen sein muss, was bei sehr vielen Kontaktpins bzw. -federn Probleme schaffen würde.

Um dennoch Strips mit einer Vielzahl kleiner, eng nebeneinander liegender Bauelemente auf wirtschaftliche Weise testen zu können, ist es beispielsweise aus der US 2005/0 162 150 A1 bekannt, zunächst nur eine Untergruppe von Bauelementen eines Strips zu kontaktieren und das Kontaktiernest nach erfolgtem Funktionstest seitlich relativ zum Testkopf zu verschieben, um anschließend eine andere Untergruppe des selben Strips zu kontaktieren. Dies erfordert jedoch aufwendige Verstellmechanismen für das Kontaktiernest innerhalb des Handlers. Die Komplexität derartiger Verstellmechanismen ist insbesondere bei Kontaktiernestern besonders hoch, die zur Durchführung von Temperaturtests auf ganz bestimmte, häufig extreme Temperaturen temperiert werden müssen. Weiterhin ist eine derartige Testmethode nicht bei Strips einsetzbar, die nicht automatisch über einen Handler, sondern manuell dem Testkopf zugeführt werden.

Aus der US 6,404,212 B1 ist eine Testvorrichtung gemäß dem Oberbegriff des Anspruches 2 bekannt. Dort wird lediglich allgemein auf ein Kontaktierboard mit einem dreidimensionalen Bewegungsfreiraum hingewiesen, ohne dass nähere Ausführungen gemacht werden, wie dieser erreicht wird.

Aus der US 2005/280427 A1 ist weiterhin eine Testvorrichtung zum gleichzeitigen Testen einer Mehrzahl von elektronischen Bauelementen bekannt. Bei dieser bekannten Testvorrichtung ist eine Grundplatte mit einer zentralen Öffnung vorgesehen, die von einer Mehrzahl paralleler Trageschienen überspannt wird. Die Trageschienen sind beidseitig auf Schienen gelagert und in Y-Richtung verstellbar. An den Trageschienen sind wiederum eine Mehrzahl von Kontaktkartenhaltern zum Halten von Kontaktkarten (probe cards) angeordnet, die mit den zu testenden Bauelementen in Kontakt gebracht werden können. Die Kontaktkartenhalter können an den Trageschienen in unterschiedlichen X-Position arretiert werden. Weiterhin kann ein Einschub für die Kontaktkarten mittels einer Mikrometerschraube in Z-Richtung, d.h. in vertikaler Richtung, manuell verstellt werden.

Aus der US 2002/00711271 ist weiterhin eine Positioniereinrichtung für eine Kontaktkarte bekannt, mit der die XY-Position der Kontaktkarte relativ zu den zu testenden Bauelementen korrigiert werden kann, falls die Kontakte der Bauelemente nicht exakt auf dem entsprechenden Kontakten der Kontaktkarte zu liegen kommen.

Aus der US 2006/0066340 A1 ist weiterhin eine Testvorrichtung zum Testen von auf einem Trägerband angeordneten elektronischen Bauelementen bekannt, wobei das Band mit den Bauelementen an einer Kontaktkarte der Testvorrichtung vorbeigeführt und in bestimmten Positionen mit dieser kontaktiert werden.

Der Erfindung liegt die Aufgabe zugrunde, ein Verfahren und eine Testvorrichtung zum Testen von elektronischen Bauelementen zu schaffen, das bzw. die eine besonders hohe Zuverlässigkeit und Genauigkeit beim Testen von nebeneinander in einem Verbund vorliegenden Bauelementen aufweist und das Testen einer Vielzahl eng nebeneinander liegender Bauelemente auf besonders wirtschaftliche Weise ohne komplexe Verstelleinrichtungen für das Kontaktiernest ermöglicht.

Diese Aufgabe wird erfindungsgemäß durch ein Verfahren mit den Merkmalen des Anspruches 1 und eine Testvorrichtung mit den Merkmalen des Anspruches 2 gelöst. Vorteilhafte Ausführungsformen der Erfindung sind in den weiteren Ansprüchen beschrieben.

Das erfindungsgemäße Verfahren ist durch folgende Schritte **gekennzeichnet:**
- Einlegen von zu testenden Bauelementen in ein Kontaktiernest,
- Andocken des Kontaktiernestes an einen Testkopf, der eine Kontaktierboardstützeinrichtung in der Form eines Schlittens aufweist, der an mindestens einer Führungsschiene einer Testkopfkonsole des Testkopfs verfahrbar ist und ein Kontaktierboard mit einer Vielzahl von Kontaktelementen in der Form von Kontaktpins oder Kontaktfedern trägt, wobei die Kontaktierboardstützeinrichtung ein an der Führungsschiene gehaltertes Schieneneingriffsteil und eine senkrecht zu diesem verfahrbare Kontaktierboardstützeinheit aufweist,
- Kontaktieren der Kontaktelemente des Kontaktierboards mit einer ersten Gruppe von Anschlusskontakten der Bauelemente durch Verfahren der Kontaktierboardstützeinheit senkrecht zum Schieneneingriffsteil bei am Testkopf angedocktem Kontaktiernest, und Durchführen des Tests,
- Entfernen des Kontaktierboards von den Bauelementen bei am Testkopf angedocktem Kontaktiernest,
- seitliches Verfahren der Kontaktierboardstützeinrichtung bei am Testkopf angedocktem Kontaktiernest, bis die Kontaktelemente des Kontaktierboards einer zweiten Gruppe von Anschlusskontakten der Bauelemente gegenüberliegen,
- Kontaktieren der Kontaktelemente des Kontaktierboards mit der zweiten Gruppe von Anschlusskontakten durch Verfahren der Kontaktierboardstützeinheit senkrecht zum Schieneneingriffsteil bei am Testkopf angedocktem Kontaktiernest, und Durchführen des Tests,
- Entfernen des Kontaktierboards von den Bauelementen.

Das erfindungsgemäße Verfahren ermöglicht auf besonders wirtschaftliche Weise das Testen einer Vielzahl eng nebeneinander liegender Bauelemente, ohne dass hoch komplexe Verstellmechanismen erforderlich wären, wie dies bei Testvorrichtungen der Fall ist, bei denen das Kontaktiernest während des Testvorgangs bewegt wird.

Bei der erfindungsgemäßen Vorrichtung weist der Testkopf einen motorischen Schlittenantrieb auf, mit dem die Kontaktierboardstützeinrichtung bei am Testkopf angedocktem Kontaktiernest von einer ersten Testposition, in der die Kontaktelemente des Kontaktierboards einer ersten Gruppe von Anschlusskontakten der zu testenden Bauelemente gegenüber liegen, in eine zweite Testposition verfahrbar ist, in der die Kontaktelemente des Kontaktierboards einer zweiten Gruppe von Anschlusskontakten der zu testenden Bauelemente gegenüber liegen. Weiterhin ist das Kontaktierboard senkrecht zur Kontaktierboardebene bewegbar, so dass es bei am Testkopf angedocktem Kontaktiernest auf die Bauelemente zu und von diesem weg bewegbar ist.

Bei der erfindungsgemäßen Testvorrichtung erfolgt somit der Positionswechsel zum Kontaktieren der Kontaktflächen der Bauelemente eines Strips durch die Veränderung der Position des Kontaktierboards relativ zum Strip, während das Kontaktiernest seine einmal eingenommene Andockposition am Testkopf unverändert beibehält. Dadurch, dass der gesamte Verstellmechanismus zum seitlichen Bewegen des Kontaktierboards am Testkopf angeordnet ist, kann die Baugruppe innerhalb des Handlers, in der das Kontaktiernest gehandhabt wird, im Vergleich zu solchen Testvorrichtungen, bei denen das Kontaktiernest während des Testvorgangs bewegt wird, wesentlich einfacher gestaltet werden. Weiterhin wird das Kontaktierboard durch die Kontaktierboardstützeinrichtung stabilisiert. Ein Durchbiegen des Kontaktierboards kann zuverlässig verhindert werden.

Das Kontaktierboard führt dabei relativ zum Testkopf eine Hubbewegung aus, die erforderlich ist, um zu verhindern, dass die Kontaktpins bzw. -federn auf den Bauelementen entlang schleifen, während das Kontaktierboard seitlich in die nächste Testposition bewegt wird.

Ein besonderer Vorteil der erfindungsgemäßen Testvorrichtung liegt darin, dass das Prinzip des seitlich verschiebbaren Kontaktierboards auch bei Testvorrichtungen eingesetzt werden kann, die zum Testen und Kalibrieren mikroelektronischer Bauelemente (z.B. MEMS) dienen, die während des Funktionstests in einen bestimmtem Neigungswinkel bezüglich der Erdsenkrechten gebracht werden müssen. Neben statischen Funktionstests können dabei auch dynamische Tests durchgeführt werden, wobei die Bauelemente um eine oder zwei senkrecht zueinander stehende Achsen dynamisch geschwenkt werden. Hierbei wird das am Testkopf festgeklemmte Kontaktiernest in entsprechender Weise geneigt bzw. geschwenkt, wobei es bisher nicht möglich war, einen Strip auf schnelle Weise dadurch zu testen, dass die Relativposition zwischen Bauelementen und Kontaktierboard verändert wird. Weiterhin kann die erfindungsgemäße Vorrichtung auch bei Testmodulen eingesetzt werden, die nicht automatisch über einen Handler, sondern manuell bestückt und beispielsweise auf einem Tisch aufgesetzt werden.

Gemäß einer vorteilhaften Ausführungsform weist die Kontaktierboardstützeinrichtung ein an mindestens einer Führungsschiene der Testkopfkonsole verschiebbar geführtes Schieneneingriffsteil und ein Kontaktierboardstützteil auf, das relativ zum Schieneneingriffsteil und senkrecht zur Kontaktierboardebene verschiebbar am Schieneneingriffsteil gehalten ist, wobei ein Hubmechanismus vorgesehen ist, mit dem das Kontaktierboardstützteil zusammen mit dem Kontaktierboard bei angedocktem Kontaktiernest von den Bauelementen entfernbar und an diese annäherbar ist. Der Hubmechanismus umfasst hierbei vorzugsweise Hebel mit Stößeln, die durch eine Schwenkbewegung der Hebel in Hubrichtung bewegbar sind, um das Kontaktierboardstützteil in Kontaktierrichtung zu bewegen. Weiterhin ist zweckmäßigerweise zwischen dem Schieneneingriffsteil und dem Kontaktierboardstützteil eine Rückzugeinrichtung in der Form von Federn wirksam, um das Kontaktierboardstützteil entgegen der Kontaktierrichtung in eine zurückgezogene Stellung zu bewegen. Mit einer derartigen Ausführung kann die erforderliche Hubbewegung des Kontaktierboards relativ zu den Bauelementen auf schnelle, zuverlässige und relativ einfache Weise bewirkt werden.

Die Erfindung wird nachfolgend anhand der Zeichnungen beispielhaft näher erläutert. Es zeigen:
- Figur 1 :: eine auf einem lediglich schematisch dargestellten Handler oder Tisch angeordnete Testvorrichtung gemäß der Erfindung,
- Figur 2 :: die Testvorrichtung von Figur 1 in Alleinstellung,
- Figur 3 :: einen Testkopf mit Schwenkrahmen schräg von oben in Alleinstellung,
- Figur 4 :: einen Testkopf in Alleinstellung schräg von unten, wobei das Kontaktierboard in einer ersten Position dargestellt ist,
- Figur 5 :: eine der Figur 4 entsprechende Darstellung, wobei das Kontaktierboard in einer zweiten Position dargestellt ist,
- Figur 6 :: ein teilweise schematisch dargestellter Längsschnitt durch den Testkopf der Figuren 3 und 4 (Blickrichtung von hinten, wobei das Kontaktierboard in einer mittigen Position dargestellt ist,
- Figur 7 :: eine Darstellung entsprechend Figur 6, wobei das Kontaktierboard in einer nach rechts verfahrenen Stellung dargestellt ist,
- Figur 8 :: eine Seitenansicht wesentlicher Teile einer Kontaktierboardstützeinrichtung zur Verdeutlichung des Hubmechanismus,
- Figur 9 :: eine Darstellung der Kontaktierboardstützeinrichtung von Figur 8 in einer anderen Hubstellung, und
- Figur 10 :: den Testkopf von Figur 10 schräg von unten mit einem Kontaktiernest kurz vor der Andockposition.

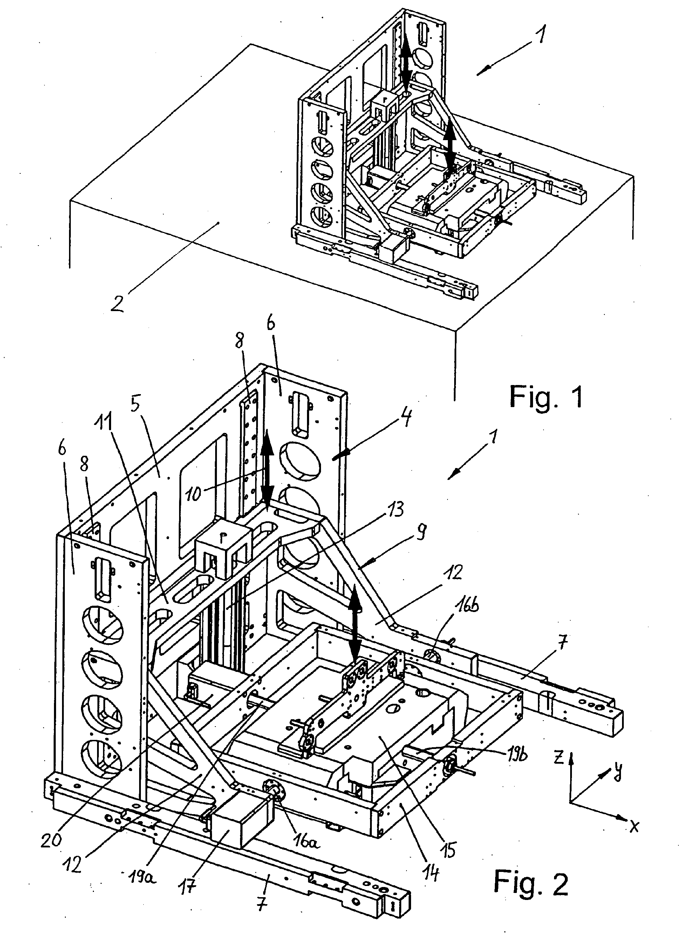

Aus Figur 1 ist eine Testvorrichtung ersichtlich, die auf der Oberseite eines lediglich schematisch dargestellten Handlers 2, d.h. eines Handhabungsautomaten für elektronische Bauelemente, oder auf einer anderen ebenen Unterlage, beispielsweise einem Tisch, befestigt bzw. aufgestellt werden kann. Die Testvorrichtung dient zum Testen von nicht näher dargestellten elektronischen Bauelementen in der Form von Halbleitern, die in einem Verbund, insbesondere in der Form von Strips, vorliegen und vor ihrer Montage auf Leiterplatten etc. einem Funktionstest, insbesondere unter speziellen thermischen Bedingungen, unterzogen werden sollen.

Im Folgenden wird anhand von Figur 2 die Testvorrichtung 1 näher beschrieben.

Die Testvorrichtung 1 weist einen äußeren Rahmen 4 auf, der eine rückseitige Vertikalplatte 5, zwei vertikale Seitenplatten 6 sowie zwei untere, horizontal angeordnete Konsolenprofile 7 umfasst.

In den Seitenbereichen weist die Vertikalplatte 5 zwei zueinander parallele, vertikal angeordnete Führungsschienen 8 auf, an denen ein Schlitten 9 längs verschiebbar geführt ist. Der Schlitten 9 kann somit in vertikaler Richtung angehoben und abgesenkt werden, wie durch den Pfeil 10 veranschaulicht ist. Der Schlitten 9 ist portalartig ausgeführt und weist ein horizontales Querjoch 11 auf, das an den Führungsschienen 8 anliegt und diese in geeigneter Weise hintergreift. An den beiden Enden des Querjochs 11 sind Seitenelemente 12 starr befestigt, die sich vom Querjoch 11 vertikal nach unten und nach vorne über dieses hinaus erstrecken.

Zur Vertikalbewegung des Schlittens 9 ist ein Hubmechanismus in der Form eines zweckmäßigerweise pneumatisch wirkenden Hubzylinders 13 vorgesehen, der einerseits am Querjoch 11 und andererseits an der Vertikalplatte 5 angreift. Durch Ausfahren des Hubzylinders 13 wird der Schlitten 9 angehoben und durch Zusammenziehen des Zylinders 13 in die in Figur 2 gezeigte Stellung abgesenkt.

Der Schlitten 9 dient zum schwenkbaren Halten eines Schwenkrahmens 14, der wiederum einen Testkopf 15 schwenkbar trägt. Der Schwenkrahmen 14 ist mittels fluchtend zueinander angeordneter Schwenkachsenelemente 16a, 16b verschwenkbar in den Seitenelementen 12 des Schlittens 9 gelagert. Das Schwenken des Schwenkrahmens 14 erfolgt über einen Schwenkantrieb 17, der auf das Schwenkachsenelement 16a einwirkt.

Weiterhin kann der Testkopf 15 relativ zum Schwenkrahmen 14 um die X-Achse geschwenkt werden. Hierzu stehen von den gegenüberliegenden Seiten des Testkopfs 15 zueinander fluchtende Schwenkachsenelemente 19a, 19b vor, die drehbar im Schwenkrahmen 14 gelagert sind. Das Verschwenken des Testkopfs 15 relativ zum Schwenkrahmen 14 erfolgt über einen Schwenkantrieb 20, der am Schwenkrahmen 14 befestigt ist und auf das Schwenkachsenelement 19a des Testkopfs 15 einwirkt.

Der Testkopf 15 ist somit am Schlitten 9 kardanisch aufgehängt und um zwei zueinander senkrecht liegende Schwenkachsen schwenkbar, so dass der Testkopf 15 entweder statisch eine vorbestimmte Neigung zur Erdsenkrechten einnehmen kann oder dynamisch um eine oder zwei Achsen geschwenkt werden kann.

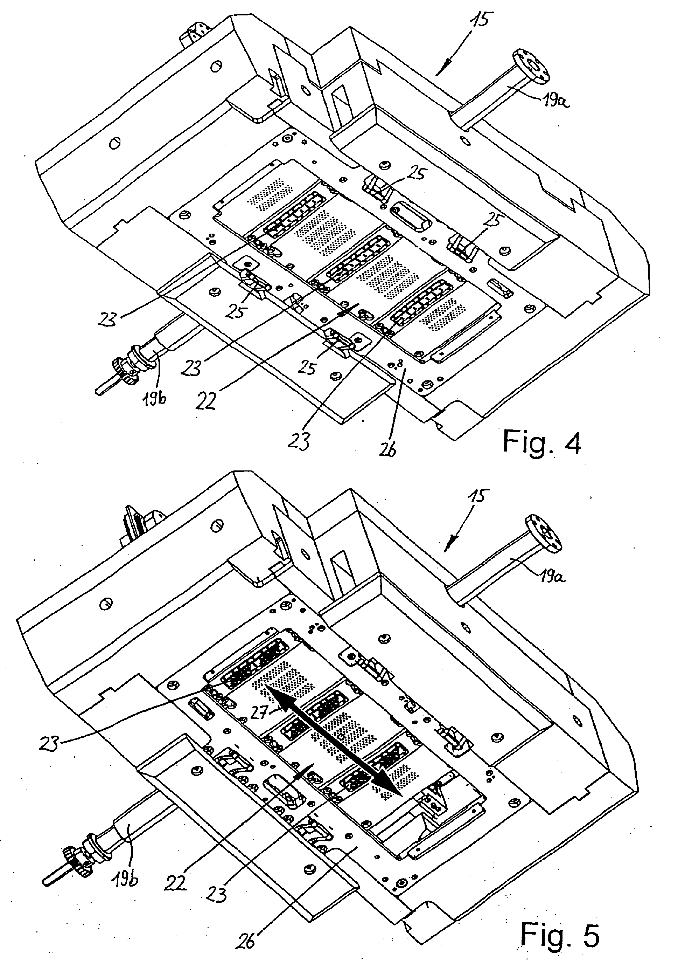

Wie aus den Figuren 4 und 5 ersichtlich, weist der Testkopf 15 an seiner Unterseite ein Kontaktierboard 22 (DUT-Board) mit drei Kontaktsockeln 23 auf. An den Kontaktsockeln 23 ist jeweils eine Vielzahl von Kontaktpins vorgesehen, die von unten zugänglich sind. Die Kontaktpins sind dabei derart angeordnet, dass sie auf entsprechende Anschlusskontakte von Bauelementen, die in einem Verbund, insbesondere in der Form von Strips, vorliegen, aufgesetzt werden können, so dass eine elektrische Verbindung zwischen den Bauelementen und einer elektronischen Testeinrichtung geschaffen werden kann.

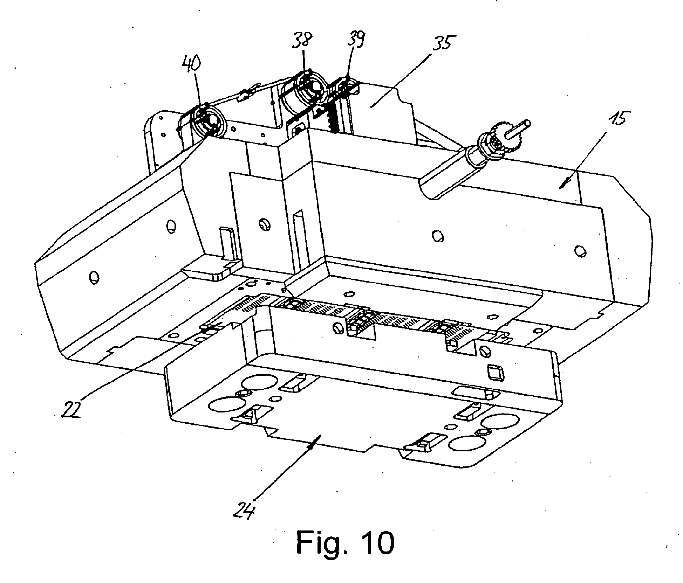

Zum Testen eines Strips wird dieser zunächst von oben in ein Kontaktiernest 24 eingelegt, das aus Figur 10 ersichtlich ist. Dies kann entweder innerhalb eines Handlers automatisch über entsprechende Transporteinrichtungen (Pick and Place Einheit) oder auch manuell erfolgen. Soll der Funktionstest der Bauelemente bei bestimmten Temperaturen erfolgen, werden die Strips entsprechend vortemperiert und zweckmäßigerweise sowohl bei ihrem Transport in das Kontaktiernest als auch im Kontaktiernest 24 selbst weiter temperiert. Anschließend wird das Kontaktiernest 24 beispielsweise mittels einer nicht dargestellten Hubeinrichtung eines Handlers hochgehoben und an der Unterseite des Testkopfs 15 angedockt, so dass die Kontaktpins des Kontaktierboards 22 auf die entsprechenden Anschlusskontakte der zu testenden Bauelemente aufgesetzt werden. Figur 10 zeigt das Kontaktiernest 24 kurz vor dem Andocken am Testkopf 15.

Während des Tests der Bauelemente wird das Kontaktiernest 24 mittels Halteeinrichtungen 25 (Figuren 4, 5) fest an der Unterseite des Testkopfs 15 gehalten, wobei das Kontaktierboard 22 an einer stationären, bodenseitigen Andockplatte 26 des Testkopfs 15 anliegt.

Wie aus einem Vergleich der Figuren 4 und 5 hervorgeht und durch den Pfeil 27 von Figur 5 verdeutlicht wird, ist das Kontaktierboard 22 verschiebbar am Testkopf 15 angeordnet. Die Verschiebung erfolgt dabei in der Kontaktierboardebene und zweckmäßigerweise in Längsrichtung des Testkopfs 15. Alternativ hierzu ist es jedoch auch möglich, das Kontaktierboard 22 in Querrichtung des Testkopfs 15 zu verschieben. Eine Verschiebung des Kontaktierboards 22 wird durchgeführt, um die Position der Kontaktierpins, die im gezeigten Ausführungsbeispiel in drei voneinander getrennten Kontaktsockeln 23 am Kontaktierboard 22 angeordnet sind, relativ zu den zugeordneten Anschlusskontakten der Bauelemente zu ändern, die unverschiebbar innerhalb des Kontaktiernests 24 liegen. Durch Veränderung der Position des Kontaktierboards 22 können somit nacheinander mehrere nebeneinander liegende Gruppen von Bauelementen eines Strips getestet werden, ohne dass das Kontaktiernest 24 vom Testkopf 15 entfernt und das Kontaktiernest 24 bzw. der Strip neu ausgerichtet werden müsste.

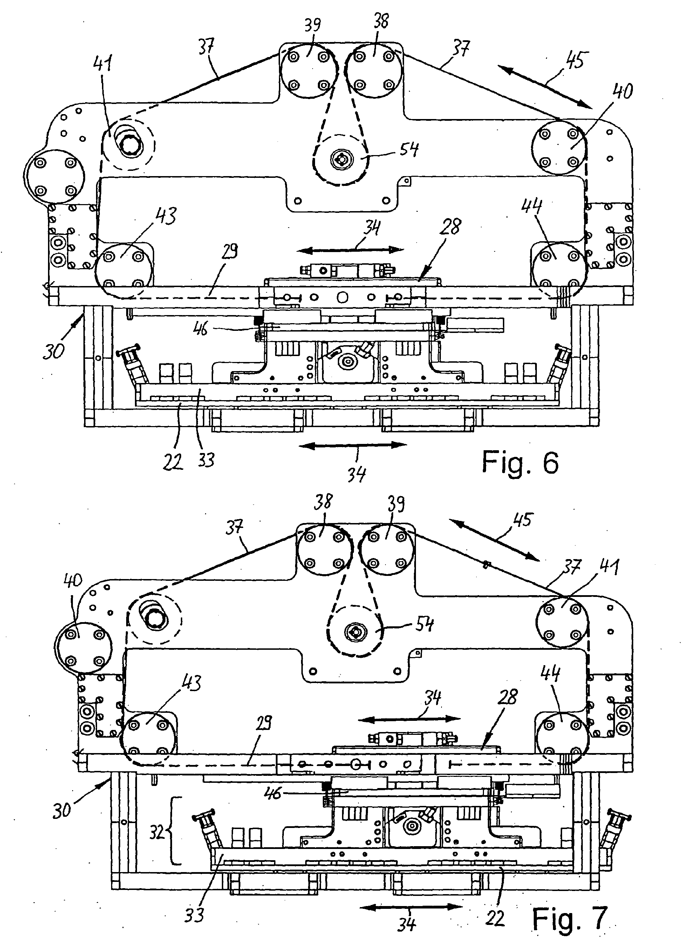

Um das Kontaktierboard 22 relativ zum übrigen Testkopf 15 seitlich verfahren zu können, weist der Testkopf 15 eine aus den Figuren 6 und 7 ersichtliche Kontaktierboardstützeinrichtung 28 auf, die in der Form eines Schlittens ausgebildet und an mindestens einer Führungsschiene 29 einer Testkopfkonsole 30 längs verschiebbar geführt ist. Die Führungsschiene 29 verläuft hierbei parallel zum Kontaktierboard 22.

Weiterhin besteht die Kontaktierboardstützeinrichtung 28 aus einem oberen Schieneneingriffsteil 31 und einem unteren Kontaktierboardstützteil 32. Am unteren Ende des Kontaktierboardstützteils 32 ist eine Versteifungsplatte 33 befestigt, welche zumindest im Wesentlichen die gleichen Außenabmessungen wie das Kontaktierboard 22 aufweist und eine Durchbiegung des Kontaktierboards 22 verhindert. Das Kontaktierboard 22 ist wiederum an der Unterseite der Versteifungsplatte 33 befestigt.

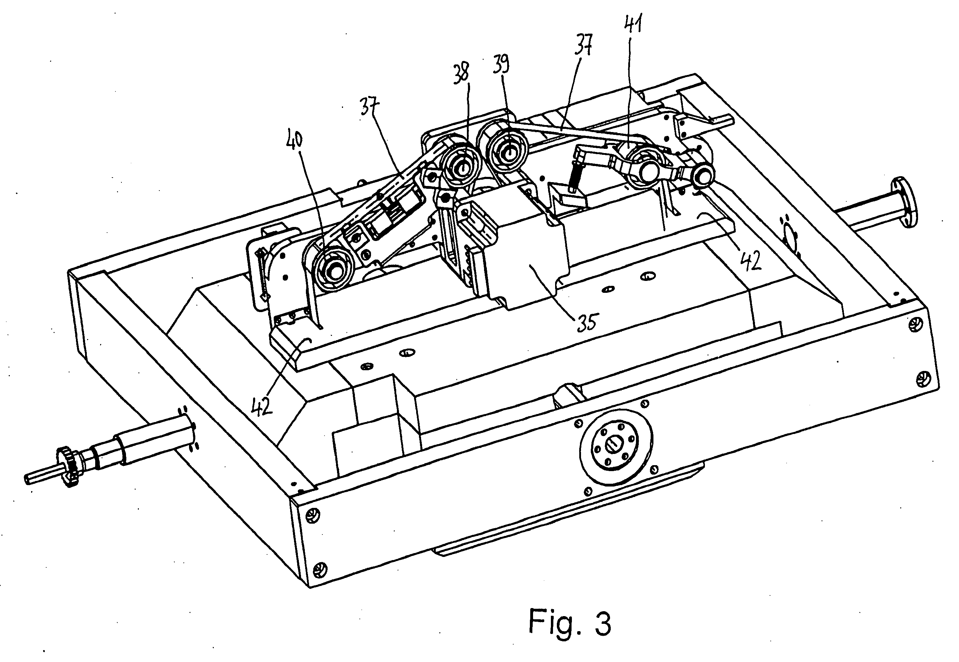

Um die Kontaktierboardstützeinrichtung 28 in Richtung der Pfeile 34 (Figuren 6 und 7) zu bewegen, ist auf der Oberseite des Testkopfs 15 ein aus Figur 3 ersichtlicher Schlittenantrieb 35 angeordnet. Beim Schlittenantrieb 35 kann es sich beispielsweise um einen Elektromotor, insbesondere Schrittmotor, handeln. Auf der Ausgangswelle des Schlittenantriebs 35 sitzt eine in Figur 3 durch den Schlittenantrieb 35 verdeckte Treibrolle 54, die ein Zugband 37 antreibt. Das Zugband 37 ist über an der Oberseite des Testkopfs 15 gelagerte Umlenkrollen 38, 39, 40, 41 in Richtung zu den gegenüberliegenden Endbereichen des Testkopfs 15 geführt und läuft dort durch Öffnungen in einer oberen Abdeckplatte 42, bei der es sich beispielsweise auch um eine Isolierschicht handeln kann, in das Innere des Testkopfs 15. Über weitere Umlenkrollen 43, 44 läuft das Zugband 37 zur Kontaktierboardstützeinrichtung 28, wo es in seinen beiden Enden an den gegenüberliegenden Seiten des Schieneneingriffsteils 31 befestigt ist. Wird das Zugband 37 durch den Schlittenantrieb 35 in Richtung des Pfeils 45 (Figuren 6, 7) bewegt, bewegt sich die gesamte Kontaktierboardstützeinrichtung 28 mit dem Kontaktierboard 22 in Richtung der Pfeile 34. Je nach Umdrehungsrichtung des Schlittenantriebs 35 kann somit das Kontaktierboard 22 nach links oder rechts relativ zum übrigen Testkopf 15 verschoben werden.

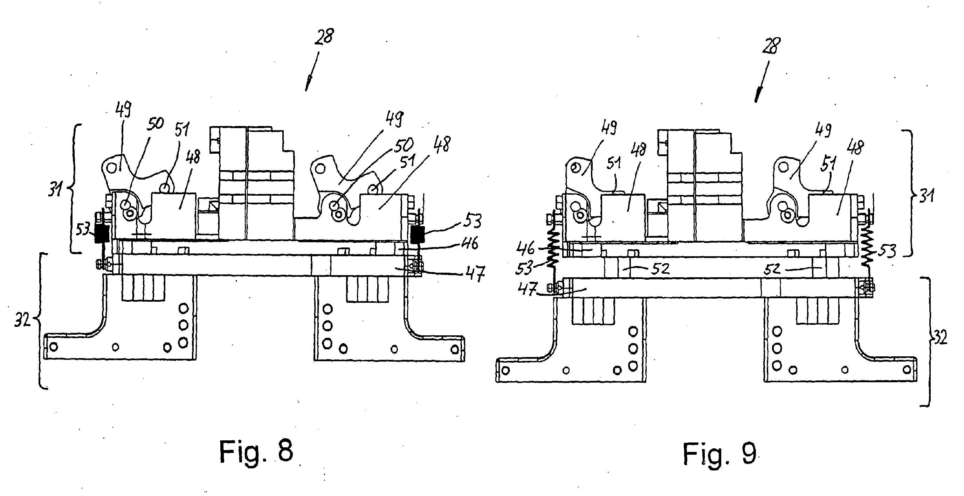

Damit bei einer Seitwärtsbewegung des Kontaktierboards 22 die Kontaktpins nicht auf den Bauelementen schleifen, muss das Kontaktierboard 22 zusätzlich eine Hubbewegung, d.h. eine Bewegung senkrecht zur Kontaktierboardebene, durchführen, so dass die Kontaktpins nach Durchführung des Funktionstests von den Anschlusskontakten der Bauelemente abgehoben werden, bevor das Kontaktierboard 22 seitlich verschoben wird und die Kontaktpins erneut auf die Anschlusskontakte anderer Bauelemente des selben Strips aufgesetzt werden. Hierzu ist das Kontaktierboardstützteil 32 höhenveränderbar am Schieneneingriffsteil 31 gelagert, wie aus den Figuren 8 und 9 ersichtlich ist. Die Kontaktierboardstützeinrichtung 28 ist dort der Übersichtlichkeit halber ohne die Versteifungsplatte 33 dargestellt.

Wie ersichtlich, weist das Schieneneingriffsteil 31 eine bodenseitige Basisplatte 46 auf, an der, wie aus Figur 8 ersichtlich, eine Kupplungsplatte 47 anliegt, die den oberen Abschluss des Kontaktierboardstützteils 32 bildet. Auf der Basisplatte 46 sind Konsolen 48 zur schwenkbaren Halterung von Hebeln 49 befestigt, die im vorliegenden Fall als L-förmige Kniehebel ausgebildet sind. Die Hebel 49 sind um Schwenkachsen 50 schwenkbar. Über einen Hebelarm 51 der Hebel 49 sind vertikal angeordnete Stößel 52 (Figur 9) vertikal bewegbar, wenn die Hebel 49 um die Schwenkachsen 50 geschwenkt werden. Die Stößel 52 sind innerhalb der Basisplatte 46 längs verschiebbar geführt und stoßen mit ihrem unteren Ende auf die Kupplungsplatte 47 oder sind an dieser befestigt. Werden die Hebel 49 von der in Figur 8 gezeigten Stellung im Uhrzeigersinn in die in Figur 9 gezeigte Stellung geschwenkt, treten die Stößel 52 nach unten über die Basisplatte 46 hinaus vor und drücken die Kupplungsplatte 47 und damit die gesamte Kontaktierboardstützeinheit 32 nach unten, wie in Figur 9 gezeigt. Das an der Kontaktierboardstützeinheit 32 befestigte Kontaktierboard 22 wird somit ebenfalls nach unten bewegt, so dass die Kontaktpins auf die Anschlusskontakte der Bauelemente aufgesetzt werden können.

Soll das Kontaktierboard 22 von den Anschlusskontakten der Bauelemente wieder abgehoben werden, um das Kontaktierboard 22 seitlich zu verfahren, werden die Hebel 49 im Gegenuhrzeigersinn in die in Figur 8 dargestellte Stellung bewegt, so dass der Druck auf die Stößel 52 aufgehoben wird. Das Kontaktierboardstützteil 32 kann dann mittels Federn 53, welche einerseits an den Konsolen 48 und andererseits an der Kupplungsplatte 47 befestigt sind, in die in Figur 8 gezeigte Stellung zurückgezogen werden, bis die Kupplungsplatte 47 wieder an die Basisplatte 46 anschlägt.

Der Antrieb zum Schwenken der Hebel 49 ist nicht näher dargestellt. Es kann sich hierbei beispielsweise um bekannte Pneumatikzylinder handeln.

## Patentansprüche

1. Verfahren zum Testen von elektronischen Bauelementen, die in einem Verbund, insbesondere in der Form von Strips, vorliegen, **gekennzeichnet durch** die vorliegenden Schritte:
- Einlegen von zu testenden Bauelementen in ein Kontaktiernest (24),
- Andocken des Kontaktiernestes (24) an einen Testkopf (15), der eine Kontaktierboardstützeinrichtung (28) in der Form eines Schlittens aufweist, der an mindestens einer Führungsschiene (29) einer Testkopfkonsole des Testkopfs (15) verfahrbar ist und ein Kontaktierboard (22) mit einer Vielzahl von Kontaktelementen in der Form von Kontaktpins oder Kontaktfedern trägt, wobei die Kontaktierboardstützeinrichtung (28) ein an der Führungsschiene (29) gehaltertes Schieneneingriffsteil (31) und eine senkrecht zu diesem verfahrbare Kontaktierboardstützeinheit (32) aufweist,
- Kontaktieren der Kontaktelemente des Kontaktierboards (22) mit einer ersten Gruppe von Anschlusskontakten der Bauelemente **durch** Verfahren der Kontaktierboardstützeinheit (32) senkrecht zum Schieneneingriffsteil (31) bei am Testkopf (15) angedocktem Kontaktiernest (24), und Durchführen des Tests,
- Entfernen des Kontaktierboards (22) von den Bauelementen bei am Testkopf (15) angedocktem Kontaktiernest (24),
- seitliches Verfahren der Kontaktierboardstützeinrichtung (28) bei am Testkopf (15) angedocktem Kontaktiernest (24), bis die Kontaktelemente des Kontaktierboards (22) einer zweiten Gruppe von Anschlusskontakten der Bauelemente gegenüberliegen,
- Kontaktieren der Kontaktelemente des Kontaktierboards (22) mit der zweiten Gruppe von Anschlusskontakten durch Verfahren der Kontaktierboardstützeinheit (32) senkrecht zum Schieneneingriffsteil (31) bei am Testkopf (15) angedocktem Kontaktiernest (24), und Durchführen des Tests,
- Entfernen des Kontaktierboards (22) von den Bauelementen.

2. Testvorrichtung zum Testen von elektronischen Bauelementen, die in einem Verbund, insbesondere in der Form von Strips, vorliegen, mit
- einem Testkopf (15),
- einem am Testkopf (15) gehaltenen Kontaktierboard (22), das eine Vielzahl von Kontaktelementen in der Form von Kontaktpins oder Kontaktfedern aufweist,
- einem Kontaktiernest (24) zur Aufnahme der zu testenden Bauelemente, wobei das Kontaktiernest (24) am Testkopf (15) andockbar ist und die Bauelemente Anschlusskontakte aufweisen, die mit den Kontaktelementen des Kontaktierboards (22) in Kontakt bringbar sind,
- wobei der Testkopf (15) eine das Kontaktierboard (22) halternde Kontaktierboardstützeinrichtung (28) aufweist, die in der Form eines Schlittens ausgebildet und an mindestens einer Führungsschiene (29) einer Testkopfkonsole des Testkopfs (15) parallel zur Kontaktierboardebene verfahrbar ist,
**dadurch gekennzeichnet, dass** der Testkopf (15) einen motorischen Schlittenantrieb (35) aufweist, mit dem die Kontaktierboardstützeinrichtung (28) bei am Testkopf (15) angedocktem Kontaktiernest (24) von einer ersten Testposition, in der die Kontaktelemente des Kontaktierboards (22) einer ersten Gruppe von Anschlusskontakten der zu testenden Bauelemente gegenüberliegen, in eine zweite Testposition verfahrbar ist, in der die Kontaktelemente des Kontaktierboards (22) einer zweiten Gruppe von Anschlusskontakten der zu testenden Bauelemente gegenüberliegen, und dass das Kontaktierboard (22) senkrecht zur Kontaktierboardebene bewegbar ist, so dass es bei am Testkopf (15) angedocktem Kontaktiernest (24) auf die Bauelemente zu und von diesen weg bewegbar ist.

3. Testvorrichtung nach Anspruch 2, **dadurch gekennzeichnet, dass** der Schlittenantrieb (35) ein Zugband (37) aufweist, das über Umlenkrollen (38, 39, 40, 41, 43, 44) geführt und an der Kontaktierboardstützeinrichtung (28) befestigt ist.

4. Testvorrichtung nach Anspruch 2 oder 3, **dadurch gekennzeichnet, dass** die Kontaktierboardstützeinrichtung (28) ein an mindestens einer Führungsschiene (29) der Testkopfkonsole (30) verschiebbar geführtes Schieneneingriffsteil (31) und ein Kontaktierboardstützteil (32) aufweist, das relativ zum Schieneneingriffsteil (31) und senkrecht zur Kontaktierboardebene verschiebbar am Schieneneingriffsteil (31) gehaltert ist, und dass ein Hubmechanismus vorgesehen ist, mit dem das Kontaktierboardstützteil (32) zusammen mit dem Kontaktierboard (22) bei angedocktem Kontaktiernest (24) von den Bauelementen entfernbar und an diese annäherbar ist.

5. Testvorrichtung nach Anspruch 4, **dadurch gekennzeichnet, dass** der Hubmechanismus Hebel (49) mit Stößeln (52) umfasst, die durch eine Schwenkbewegung der Hebel (49) in Hubrichtung bewegbar sind und das Kontaktierboardstützteil (32) in Kontaktierrichtung bewegen.

6. Testvorrichtung nach Anspruch 4 oder 5, **dadurch gekennzeichnet, dass** zwischen dem Schieneneingriffsteil (31) und dem Kontaktierboardstützteil (32) eine Rückzugeinrichtung in der Form von Federn (53) vorgesehen ist, um das Kontaktierboardstützteil (32) entgegen der Kontaktierrichtung in eine zurückgezogene Stellung zu bewegen.

## Claims

1. Method for the testing of electronic components which are present in an assembly, in particular in the form of strips, **characterised by** the available steps:
- placing components to be tested in a contacting nest (24),
- docking the contacting nest (24) to a test head (15) which has a contacting board supporting device (28) in the form of a slide which can be moved on at least one guide rail (29) of a test head bracket of the test head (15) and which carries a contacting board (22) having a plurality of contact elements in the form of contact pins or contact springs, the contacting board supporting device (28) having a rail engagement part (31) held on the guide rail (29) and a moveable contacting board supporting unit (32) perpendicular to this,
- contacting the contact elements of the contacting board (22) with a first group of connection contacts of the components by moving the contacting board supporting unit (32) perpendicularly to the rail engagement part (31) when the contacting nest (24) is docked to the test head (15) and carrying out the test,
- removing the contacting board (22) from the components when the contacting nest (24) is docked to the test head (15),
- moving the contacting board supporting device (28) sideways when the contacting nest (24) is docked to the test head (15) until the contact elements of the contacting board (22) are situated opposite a second group of connection contacts of the components,
- contacting the contact elements of the contacting board (22) with the second group of connection contacts by moving the contacting board supporting unit (32) perpendicularly to the rail engagement part (31) when the contacting nest (24) is docked to the test head (15) and carrying out the test,
- removing the contacting board (22) from the components.

2. Test apparatus for the testing of electronic components which are present in an assembly, in particular in the form of strips, having
- a test head (15),
- a contacting board (22) held at the test head (15), which has a plurality of contact elements in the form of contact pins or contact springs,
- a contacting nest (24) to accommodate the components to be tested, in which the contacting nest (24) can be docked to the test head (15) and the components have connection contacts which can be brought into contact with the contact elements of the contacting board (22),
- in which the test head (15) has a contacting board supporting device (28) holding the contacting board (22), which is designed in the form of a slide and can be moved on least at one guide rail (29) of a test head bracket of the test head (15) parallel to the plane of the contacting board,
**characterised in that** the test head (15) has a motorized slide drive (35) with which the contacting board supporting device (28) when the contacting nest (24) is docked to the test head (15) can be moved from a first test position, in which the contact elements of the contacting board (22) are situated opposite a first group of connection contacts of the components to be tested, into a second test position, in which the contact elements of the contacting board (22) are situated opposite a second group of connection contacts of the components to be tested, and **in that** the contacting board (22) can be moved perpendicularly to the plane of the contacting board so that it can be moved to the components and away from them when the contacting nest (24) is docked to the test head (15).

3. Test apparatus according to Claim 2, **characterised in that** the slide drive (35) has a drawing band (37), which is guided via deflection rollers (38, 39, 40, 41, 43, 44) and is secured to the contacting board supporting device (28).

4. Test apparatus according to Claim 2 or 3, **characterised in that** the contacting board supporting device (28) has a rail engagement part (31) guided so as to move on at least one guide rail (29) of the test head bracket (30) and a contacting board supporting part (32) which is held on the rail engagement part (31) so as to move relative to the rail engagement part (31) and perpendicular to the plane of the contacting board, and **characterised in that** a lifting mechanism is provided, with which the contacting board supporting part (32) together with the contacting board, when the contacting nest (24) is docked, can be removed from the components and can be brought close to them.

5. Test apparatus according to Claim 4, **characterised in that** the lifting mechanism comprises levers (49) with rams (52) which can be moved by a pivoting movement of the levers (49) in the lifting direction and move the contacting board supporting part (32) in the contacting direction.

6. Test apparatus according to Claim 4 or 5, **characterised in that** a withdrawal device in the form of springs (53) is provided between the rail engagement part (31) and the contacting board supporting part (32), in order to move the contacting board supporting part (32) against the contacting direction into a withdrawn position.

## Revendications

1. Procédé pour tester des composants électroniques qui se présentent sous la forme d'un assemblage, en particulier sous la forme d'un ruban, **caractérisé par** les étapes suivantes :
- introduction d'éléments à tester dans une niche de mise en contact (24),
- accrochage de la niche de mise en contact (24) sur une tête de test (15), qui présente des moyens de soutien de carte de mise en contact (28) sous la forme d'un chariot, celui-ci étant déplaçable sur au moins un rail de guidage (29) d'une console de la tête de test (15), et qui porte une carte de mise en contact (22) avec une pluralité d'éléments de contact sous la forme de tiges de contact ou de lamelles de contact, lesdits moyens de soutien de carte de mise en contact (28) comprenant une partie d'engagement de rail (31) retenue sur le rail de guidage (29) et une unité de soutien de carte de mise en contact (32) déplaçable perpendiculairement à cette partie,
- mise en contact des éléments de contact de la carte de mise en contact (22) avec un premier groupe de contacts de raccordement des composants par déplacement de l'unité de soutien de carte de mise en contact (32) perpendiculairement à la partie d'engagement de rail (31) lorsque la niche de mise en contact (24) est accrochée sur la tête de tests (15), et exécution du test,
- enlèvement de la carte de mise en contact (22) depuis les composants lorsque la niche de mise en contact (24) est accrochée sur la tête de test (15),
- déplacement latéral des moyens de soutien de carte de mise en contact (28) alors que la niche de mise en contact (24) est accrochée sur la tête de test (15), jusqu'à ce que les éléments de contact de la carte de mise en contact (22) se trouvent à l'opposé d'un second groupe de contacts de raccordement des composants,
- mise en contact des éléments de contact de la carte de mise en contact (22) avec le second groupe de contacts de raccordement par déplacement de l'unité de soutien de carte de mise en contact (32) perpendiculairement à la partie d'engagement de rail (31) alors que la niche de mise en contact (24) est accrochée sur la tête de test (15), et exécution du test,
- enlèvement de la carte de mise en contact (22) depuis les composants.

2. Dispositif de test pour tester des composants électroniques qui se présentent sous la forme d'un assemblage, en particulier sous la forme d'un ruban, comprenant :
- une tête de test (15),
- une carte de mise en contact (22) maintenue sur la tête de test (15), qui comprend une pluralité d'éléments de contact sous la forme de tiges de contact ou de lamelles de contact,
- une niche de mise en contact (24) pour recevoir les composants à tester, la niche de mise en contact (24) pouvant être accrochée sur la tête de test (15), et les composants comportant des contacts de raccordement qui peuvent être mis en contact avec les éléments de contact de la carte de mise en contact (22),
- dans lequel la tête de test (15) comprend des moyens de soutien de carte de mise en contact (28) qui maintiennent la carte de mise en contact (22), qui sont réalisés sous la forme d'un chariot et qui sont déplaçables sur au moins un rail de guidage (29) d'une console de la tête de test (15) parallèlement au plan de la carte de mise en contact,
**caractérisé en ce que** la tête de test (15) comprend un entraînement de chariot motorisé (35), au moyen duquel les moyens de soutien de carte de mise en contact (28), lorsque la niche de mise en contact (24) est accrochée sur la tête de test (15), sont déplaçables depuis une première position de test dans laquelle les éléments de contact de la carte de mise en contact (22) sont situés à l'opposé d'un premier groupe de contacts de raccordement des composants à tester, jusque dans une seconde position de test dans laquelle les éléments de contact de la carte de mise en contact (22) sont situés à l'opposé d'un second groupe de contacts de raccordement des composants à tester, et **en ce que** la carte de mise en contact (22) est déplaçable perpendiculairement au plan de la carte de mise en contact, de sorte qu'elle peut être rapprochée et éloignée des composants alors que la niche de mise en contact (24) est accrochée sur la tête de test (15).

3. Dispositif de test selon la revendication 2, **caractérisé en ce que** l'entraînement de chariot (35) comprend une bande de traction (37) qui est guidée sur des galets de renvoi (38, 39, 40, 41, 43, 44) et qui est fixée sur les moyens de soutien de carte de mise en contact (28).

4. Dispositif de test selon la revendication 2 ou 3, **caractérisé en ce que** les moyens de soutien de carte de mise en contact (28) comprennent une partie d'engagement de rail (31) guidée en déplacement sur au moins un rail de guidage (29) de la console (30) de la tête de test, et une partie de soutien de carte de mise en contact (32) qui est maintenue sur la partie d'engagement de rail (31) par rapport à la partie d'engagement de rail (31) et en déplacement perpendiculairement au plan de la carte de mise en contact, et **en ce qu'**il est prévu un mécanisme de levage au moyen duquel la partie de soutien de carte de mise en contact (32) peut être éloignée et rapprochée des composants, conjointement avec la carte de mise en contact (22) lorsque la niche de mise en contact (24) est accrochée.

5. Dispositif de test selon la revendication 4, **caractérisé en ce que** le mécanisme de levage comprend des leviers (49) avec des poussoirs (52), lesquels sont déplaçables en direction de levage par un mouvement de pivotement des leviers (49), et déplacent la partie de soutien de carte de mise en contact (32) dans la direction de mise en contact.

6. Dispositif de test selon la revendication 4 ou 5, **caractérisé en ce qu'**il est prévu entre la partie d'engagement de rail (31) et la partie de soutien de carte de mise en contact (32) un dispositif de rappel sous forme de ressort (53), pour déplacer la partie de soutien de carte de mise en contact (32) jusque dans une position de rappel, à l'encontre de la direction de mise en contact.
